Europäisches Patentamt

European Patent Office

Office européen des brevets

(11) Veröffentlichungsnummer: **0 277 692**
**A2**

(12) # EUROPÄISCHE PATENTANMELDUNG

(21) Anmeldenummer: **88200153.0**

(51) Int. Cl.⁴: **H03J 5/24**

(22) Anmeldetag: **29.01.88**

(30) Priorität: **05.02.87 DE 3703406**

(43) Veröffentlichungstag der Anmeldung:
**10.08.88 Patentblatt 88/32**

(84) Benannte Vertragsstaaten:
**DE ES GB IT**

(71) Anmelder: **Philips Patentverwaltung GmbH
Wendenstrasse 35 Postfach 10 51 49
D-2000 Hamburg 1(DE)**

(84) **DE**

(71) Anmelder: **N.V. Philips' Gloeilampenfabrieken
Groenewoudseweg 1
NL-5621 BA Eindhoven(NL)**

(84) **ES GB IT**

(72) Erfinder: **Kupfer, Karl-Heinz
Krefelder Strasse 145
D-4150 Krefeld(DE)**

(74) Vertreter: **Kupfermann, Fritz-Joachim,
Dipl.-Ing. et al
Philips Patentverwaltung GmbH
Wendenstrasse 35 Postfach 10 51 49
D-2000 Hamburg 1(DE)**

(54) **Kombinierter ZF-Saug- und Parallelkreis für einen Fernseh-Tuner.**

(57) Bei einer Schaltungsanordnung für einen Fernseh-Tuner zum Zusammenschalten eines VHF-Signals und eines auf eine Zwischenfrequenz umgesetzten UHF-Signals auf einen gemeinsamen Eingang eines Mischer/Verstärkers ist vorgesehen, daß die beiden Signalzweige am Mischer/Verstärker-Eingang gegenseitig gekoppelt sind, die Eingangsimpedanz des Mischer/Verstärkers induktiv gewählt ist und der UHF-ZF-Kreis als Parallelschwingkreis ausgelegt ist, in den die induktive Impedanz des Mischer/Verstärker-Eingangs mit einbezogen ist. Die dem Mischer/Verstärker-Eingang vorgeschalteten Bauelemente des UHF-ZF-Kreises sind bei VHF-Betrieb als zwischen Mischer/Verstärker-Eingang und Masse geschalteter, auf ZF-Frequenz arbeitender Serienschwingkreis wirksam.

Fig.2

## Kombinierter ZF-Saug-und Parallelkreis für einen Fernseh-Tuner

Die Erfindung bezieht sich auf eine Schaltungsanordnung für einen Fernseh-Tuner zum Zusammenschalten der Signalzweige eines UHF-Signales und eines mittels eines ZF-Mischers und eines ZF-Kreises auf eine Zwischenfrequenz umgesetzten UHF-Signals auf einen gemeinsamen Eingang eines Mischer/Verstärkers, der für den VHF-Bereich als Mischer und für das VHF-ZF-Signal als Verstärker arbeitet.

In Fernseh-Tunern ist es üblich, das meist mittels eines Bandfilters ausgefilterte VHF-Signal und das mittels eines ZF-Mischers und eines ZF-Kreises auf eine Zwischenfrequenz umgesetzte UHF-Signal auf einen gemeinsamen Eingang eines Mischer/Verstärkers zu schalten. Dieser Mischer/Verstärker arbeitet für den VHF-Bereich als ZF-Mischer und für das UHF-ZF-Signal als Verstärker. Für das Zusammenschalten dieser beiden Signale ist es üblich, das hinter dem UHF-ZF-Kreis auf Zwischenfrequenz umgesetzte UHF-Signal über eine Schaltdiode an den gemeinsamen Eingang des Mischer/Verstärkers zu schalten. Zusätzlich zu dieser Schaltdiode ist dann eine Schaltspannung der Schaltungsanordnung zuzuführen, mittels derer die Diode geschaltet wird. Die Diode dient damit u. a. dazu, bei eingeschaltetem VHF-Betrieb den UHF-Signalzweig zu entkoppeln. Diese Schaltungsanordnung hat den Nachteil eines relativ großen Schaltungsaufwandes und bedarf einer Schaltspannung.

Es ist Aufgabe der Erfindung, eine Schaltungsanordnung der eingangs genannten Art anzugeben, die einen möglichst einfachen und wirtschaftlichen Aufbau bietet.

Diese Aufgabe ist erfindungsgemäß dadurch gelöst, daß
-die beiden Signalzweige am Mischer/Verstärker-Eingang gegenseitig gekoppelt sind,
- die Eingangsimpedanz des Mischer/Verstärkers induktiv ist,
- der UHF-ZF-Kreis als Parallelschwingkreis ausgelegt ist, in den die induktive Impedanz des Mischer/Verstärker-Eingangs mit einbezogen ist,
- dem Mischer/Verstärker-Eingang vorgeschaltete Bauelemente des UHF-ZF-Kreises bei VHF-Betrieb als zwischen Mischer/Verstärker-Eingang und Masse geschalteter, auf ZF-Frequenz arbeitender Serienschwingkreis wirksam sind.

Der UHF-ZF-Kreis ist also als Parallelschwingkreis ausgelegt und ist gebildet mittels vor dem Eingang des Mischer/Verstärkers geschalteten Bauelementen und dem Eingang des Mischer/Verstärkers selbst. Die Eingangsimpedanz des Mischer/Verstärkers ist dabei induktiv gewählt, was beispielsweise ohne Probleme dadurch bewerkstelligt werden kann, daß eine übliche Mischer/Verstärker-Schaltung mit einem in Basisschaltung arbeitenden Transistor vorgesehen wird, dessen Eingang induktiv ist. Die induktive Eingangsimpedanz des Mischer/Verstärkers ist auf diese Weise in den UHF-ZF-Kreis mit einbezogen. Bei VHF-Betrieb ist eine Entkopplung des UHF-Signalzwelges nicht vorgesehen. Statt dessen werden die dem Mischer/Verstärker vorgeschalteten Bauelemente des UHF-Zf-Kreises so gewählt, daß sie bei VHF-Betrieb als Serienschwingkreis wirken, der gegen Masse geschaltet ist und der am Eingang des Mischer/Verstärkrs auftretende Signale mit ZF-Frequenz gegen Masse ableitet.

Diese Schaltungsanordnung bietet bei einfachem und wirtschaftlichem Aufbau darüber hinaus die Vorteile, daß keine Schaltspannung mehr benötigt wird und daß ohne zusätzliche Bauelemente für Betrieb im VHF-Bereich ein ZF-Saugkreis am Eingang des Mischer/Verstärkers wirksam ist.

Nach einer weiteren Ausgestaltung der Erfindung ist vorgesehen, daß der UHF-ZF-Kreis aus einer Induktivität, die von dessen Eingang zum Eingang des Mischer/Verstärkers führt, und einer Serienschaltung eines Widerstandes und einer Kapazität aufgebaut ist, die zwischen den Eingang des UHF-ZF-Kreises und Masse geschaltet ist.

Infolge der Einbeziehung der induktiven Eingangsimpedanz des Mischer/Verstärkers sind auf diese Weise nur noch drei passive Bauelemente dem Eingang des Mischer/Verstärkers vorzuschalten. Im UHF-Betrieb ergibt sich eine Parallelschaltung aus

1. der Induktivität, der dann wiederum in einer Parallelschaltung der Eingang des VHF-Signalbereiches und der Eingang des Mischer/Verstärkers nachgeschaltet sind, und

2. der Serienschaltung aus dem Widerstand und der Kapazität.

Diese Schaltung bildet den Parallelschwingkreis, der als UHF-ZF-Kreis wirkt.

Bei VHF-Betrieb ist zwischen dem Eingang des Mischer/Verstärkers die Reihenschaltung aus der Induktivität des UHF-ZF-Kreises und deren Serienschaltung eines Widerstandes und eine Kapazität wirksam. Diese Serienschaltung ist mit der Kapazität gegen Masse geschaltet und weist eine Resonanzfrequenz auf, die im Bereich der Zwischenfrequenz liegt.

Anhand der Zeichnungen wird ein Ausführungsbeispiel der Erfindung näher erläutert. Es zeigen:

Fig. 1 eine Schaltungsanordnung zum Zusammenschalten des VHF-Signals und des auf eine Zwischenfrequenz umgesetzten UHF-Signals nach dem Stand der Technik,

Fig. 2 eine Schaltungsanordnung zum Zusammenschalten der beiden Signale nach der Erfindung.

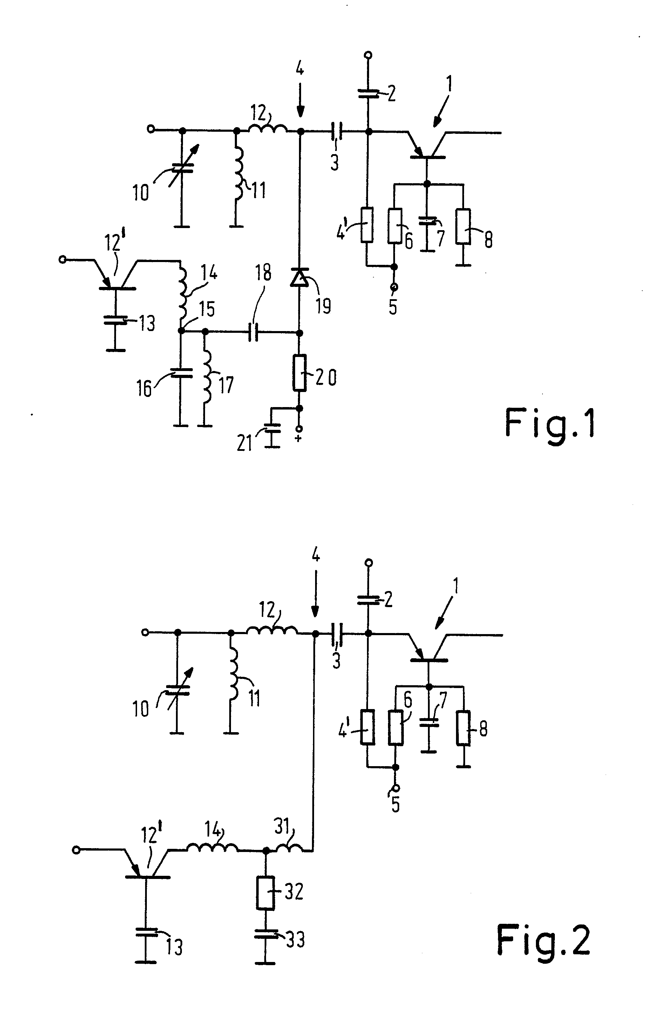

Eine in Fig. 1 dargestellte Schaltungsanordnung nach dem Stand der Technik weist einen Mischer/Verstärker auf, der mit einem in Basisschaltung arbeitenden Transistor 1 arbeitet. Der Mischer/Verstärker arbeitet für den VHF-Bereich als Mischer und für din UHF-Bereich als Verstärker des bereits auf Zwischenfrequenz umgesetzten UHF-Signals. Für die Mischer-Funktion bei VHF-Betrieb ist dem Emitter des Transistors 1 über eine Kapazität 2 ein ZF-Oszillatorsignal eines in der Figur nicht dargestellten ZF-Oszillators zugeführt. Ferner ist der Emitter des Transistors 1 über eine Koppelkapazität 3 mit dem Eingang 4 des Mischer/Verstärkers verbunden. Der Emitter des Transistors 1 ist ferner über einen Widerstand 4 mit einem Anschluß 5 einer Spannungsversorgung verbunden, der wiederum über einen weiteren Widerstand 6 mit der Basis des Transistors 1 verbunden ist. Von der Basis des Transistors 1 führt ferner eine Parallelschaltung einer Kapazität 7 und eines Widerstandes 8 gegen Masse.

An den Eingang 4 des Mischer/Verstärkers sind zwei Signalzweige geschaltet. Über den ersten Signalzweig wird dem Mischer/Verstärker nach einem Bandfilter das VHf-Signal zugeführt. Über einen zweiten Signalzweig gelangt das UHF-Signal nach einem ZF-Mischer und einem nachgeschalteten ZF-Kreis, auf eine Zwischenfrequenz umgesetzt, zum Eingang 4 des Mischer/Verstärkers.

In Fig. 1 sind eine veränderbare Kapazität 10 und eine Induktivität 11, die beide gegen Masse geschaltet sind, und eine weitere Induktivität 12, über die das VHF-Signal zum Eingang 4 des Mischer-Oszillators gelangt, dargestellt. Diese Bauelemente stellen einen Teil eines vorgeschalteten, im übrigen nicht dargestellten VHF-Bandfilters dar.

Im UHF-Signalzweig ist ein in Basisschaltung arbeitender Transistor 12 vorgesehen, der als UHF-Mischer arbeitet. Die Basis des Transistors 12 ist über eine Kapazität 13 mit Masse verbunden, und der Kollektor des Transistors 12 führt über eine Induktivität 14 zu einem Verbindungspunkt 15. Von dem Verbindungspunkt 15 führen eine Kapazität 16 und eine Induktivität 17 gegen Masse sowie eine Kapazität 18 zur Anode einer Diode 19. Die Induktivität 17 und die Kapazität 18 stellen dabei den ZF-Schwingkreis für den UHF-Bereich dar. Die Anode der Schaltdiode 19 ist über einen Widerstand 20 mit einer positiven Schaltspannung und über eine Kapazität 21 mit Masse verbunden. Die Kathode der Diode 19 ist mit dem gemeinsamen Eingang 4 des Mischer/Verstärkers verbunden.

Das UHF-Signal gelangt nach dem Mischer, dessen Schaltung mit dem Transistor 12 hier nur schematisch dargestellt ist, auf den ZF-Kreis und wird dann bei vorhandener positiver Schaltspannung über die Diode 19 dem Eingang 4 des Mischer/Verstärkers zugeführt. Bei VHF-Betrieb ist die Diode 19 gesperrt, so daß der UHF-Signalzweig von dem Eingang 4 des Mischer/Verstärkers und dem VHF-Signalzweig entkoppelt ist.

Eine in Fig. 2 dargestellte Schaltungsanordnung nach der Erfindung weist einen Mischer/Verstärker auf, der mit dem in Fig. 1 dargestellten Mischer/Verstärker identisch ist.

Das gleiche gilt für den dem Eingang 4 des Mischer/Verstärkers vorgeschalteten VHF-Signalzweig mit einem in der Figur nicht vollständig dargestellten Bandfilter.

Ebenso ist der schematisch dargestellte UHF-ZF-Mischer mit dem in Basisschaltung arbeitenden Transistor 12 der Kapazität 13 und der Induktivität 14 entsprechend der in Fig. 1 dargestellten Schaltung aufgebaut. Der UHF-ZF-Kreis ist aufgebaut aus einer der Induktivität 14 nachgeschalteten Induktivität 31, die zum Eingang 4 des Mischer/Verstärkers führt. Der Verbindungspunkt der Induktivitäten 14 und 31 ist über einen Widerstand 32 und eine Kapazität 33 gegen Masse geführt.

Für den Betrieb im UHF-Bereich ist auf diese Weise ein UHF-ZF-Kreis aufgebaut, der sich bildet aus der Parallelschaltung der Serienschaltung des Widerstandes 32 der Kapazität 33 und der Serienschaltung aus der Induktivität 31 und der induktiven Eingangsimpedanz des Mischer/Verstärkers. Der VHF-Signalzweig spielt dabei nur eine untergeordnete Rolle, da, ebenso wie bei der in Fig. 1 dargestellten Schaltungsanordnung, die Induktivität 12 des VHF-Signalbereiches bei geeigneter Dimensionierung den VHF-Bereich weitgehend gegen den UHF-ZF-Kreis abblockt.

Ist dagegen der VHF-Bereich eingeschaltet, gelangt das VHF-Signal genauso wie bei der Schaltungsanordnung nach Fig. 1 über die Induktivität 12 zum Eingang 4 des Mischer/Verstärkers. Die dem Eingang 4 des Mischer/Verstärkers vorgeschalteten Bauelemente des UHF-ZF-Kreises wirken jedoch nun als Serienschwingkreis. Vom Eingang 4 des Mischer/Verstärkers ist dieser gebildet aus der Induktivität 31, des Widestandes 32 und der Kapazität 33, die gegen Masse geschaltet ist. Bei geeigneter Wahl der Werte der Bauelemente ergibt sich so ein Serienschwingkreis, dessen Resonanzfrequenz auf Zwischenfrequenz liegt.

Für den UHF-ZF-Kreis sind lediglich noch die Bauelemente 31 bis 33 erforderlich. Es ergibt sich somit gegenüber der in Fig. 1 dargestellten Schaltungsanordnung eine deutliche Vereinfachung der Schaltung. Darüber hinaus ergibt sich der Vorteil, daß für den VHF-Bereich über einen Serienschwingkreis im ZF-Bereich liegende Signalanteile gegen Masse abgeführt werden.

## Ansprüche

1. Schaltungsanordnung für einen Fernseh-Tuner zum Zusammenschalten der Signalzweige eines UHF-Signales und eines mittels eines ZF-Mischers und eines ZF-Kreises auf eine Zwischenfrequenz umgesetzten UHF-Signals auf einen gemeinsamen Eingang eines Mischer/Verstärkers, der für den VHF-Bereich als Mischer und für das UHF-ZF-Signal als Verstärker arbeitet, dadurch gekennzeichnet, daß
-die beiden Signalzweige am Mischer/Verstärker-Eingang gegenseitig gekoppelt sind,
- die Eingangsimpedanz des Mischer/Verstärkers induktiv ist,
- der UHF-ZF-Kreis als Parallelschwingkreis ausgelegt ist, in den die induktive Impedanz des Mischer/Verstärker-Eingangs mit einbezogen ist,
- dem Mischer/Verstärker-Eingang vorgeschaltete Bauelemente des UHF-ZF-Kreises bei VHF-Betrieb als zwischen Mischer/Verstärker-Eingang und Masse geschalteter, auf ZF-Frequenz arbeitender Serienschwingkreis wirksam sind.

2.Schaltungsanordnung nach Anspruch 1, dadurch gekennzeichnet, daß der UHF-ZF-Kreis aus einer Induktivität, die von dessen Eingang zum Eingang des Mischer/Verstärkers führt, und einer Serienschaltung eines Widerstandes und einer Kapazität aufgebaut ist, die zwischen den Eingang des UHF-ZF-Kreises und Masse geschaltet ist.

Fig.1

Fig.2